# EUROPÄISCHE PATENTANMELDUNG

(11) **EP 2 482 387 A1**
(43) Veröffentlichungstag der Anmeldung: **01.08.2012**
(21) Anmeldenummer: 12000303.3
(22) Anmeldetag: 19.01.2012
(51) Int. Cl.: H01R 12/52, H05K 1/14

(54) **Vorrichtung zur elektronischen und mechanischen Verbindung von zwei nebeneinander angeordneten Leiterplatten**

(30) Priorität: 26.01.2011 DE 102011009440
(71) Anmelder: Diehl AKO Stiftung & Co. KG, 88239 Wangen im Allgäu (DE)
(72) Erfinder: Bertelsmann, Götz-Martin, 88239 Wangen (DE)
(74) Vertreter: Diehl Patentabteilung

(57) **Zusammenfassung**

Eine Vorrichtung zur elektrischen und mechanischen Verbindung von zwei nebeneinander angeordneten Leiterplatten (10, 12), wobei eine erste Leiterplatte (10) auf einer ersten Seite wenigstens eine erste Kontaktfläche (14) aufweist und eine zweite Leiterplatte (12) auf einer ersten Seite wenigstens eine erste Kontaktfläche (18) aufweist, ist erfindungsgemäß dadurch gekennzeichnet, dass die Vorrichtung eine erste Trägerplatte (22) auf der den ersten Seiten der beiden Leiterplatten (10, 12) zugewandten Seite und eine zweite Trägerplatte (24) auf der den zweiten Seiten der beiden Leiterplatten (10, 12) zugewandten Seite aufweist, wobei die erste und/oder die zweite Trägerplatte (22, 24) zumindest teilweise aus einem elektrisch isolierenden Material bestehen; die erste Trägerplatte (22) auf ihrer den beiden Leiterplatten (10, 12) zugewandten Seite wenigstens eine Kontaktfläche (32) aus einem elektrisch leitfähigen Material aufweist; und die Vorrichtung eine Spannvorrichtung (27, 28) aufweist, um die erste und die zweite Trägerplatte (22, 24) mit zumindest Endbereichen der beiden Leiterplatten (10, 12) dazwischen derart zu verbinden, dass die wenigstens eine Kontaktfläche (32) der ersten Trägerplatte (22) sowohl mit der wenigstens einen ersten Kontaktfläche (14) der ersten Leiterplatte (10) als auch mit der wenigstens einen ersten Kontaktfläche (18) der zweiten Leiterplatte (12) in Kontakt ist.

## Beschreibung

Die vorliegende Erfindung betrifft eine Vorrichtung zur elektrischen und mechanischen Verbindung von zwei nebeneinander angeordneten Leiterplatten.

Es besteht Bedarf an einer Verbindungsvorrichtung für nebeneinander angeordnete Leiterplatten, die gleichzeitig eine elektrische Verbindung und eine mechanische Verbindung der beiden Leiterplatten herstellt. Je nach Anwendungsfall besteht zudem Bedarf an einer solchen Verbindungsvorrichtung, die eine für hohe Spannungen und große Ströme geeignete elektrische Verbindung bei kleinem Verbindungswiderstand bereitstellt.

Herkömmlicherweise werden zwei nebeneinander angeordnete Leiterplatten miteinander verbunden, indem entsprechende Stecker an die Kontaktflächen der Leiterplatten gelötet werden. Diese Stecker werden je nach Konfiguration direkt oder über ein entsprechendes Verbindungskabel miteinander verbunden. Hierbei treten jedoch im Allgemeinen drei bis fünf Übergangswiderstände zwischen den Kontaktflächen der Leiterplatten und den Steckern, direkt zwischen den beiden Steckern oder zwischen dem Verbindungskabel und den Steckern auf. Dies führt zumeist zu einem hohen Vormontageaufwand und zu großen Verbindungswiderständen an / zwischen den Leiterplatten.

Weiter beschreibt die DE 10 2004 037 629 A1 ein Verbindungselement für nebeneinander angeordnete Leiterplatten, das im Wesentlichen aus einem elektrisch leitfähigen Grundkörper besteht, dessen Endbereiche mit Kontaktflächen auf den benachbarten Leiterplatten verlötet werden können und der mit einer Sollknick- oder Sollbiegestelle ausgebildet ist, sodass die gegenseitige Ausrichtung der benachbarten und verbundenen Leiterplatten variiert werden kann.

Die DE 10 2007 057 444 A1 offenbart eine Verbindungsvorrichtung zur flexiblen elektrischen Verbindung von nebeneinander angeordneten Leiterplatten, die mehrere nebeneinander angeordnete flexible Leiter enthält, die von einer gemeinsamen Isolierung umgeben sind und deren Enden mit Kontaktelementen versehen sind, die in entsprechende Gegenkontaktelemente in den Leiterplattenkörpern eingepresst werden können.

Der Erfindung liegt die Aufgabe zugrunde, eine verbesserte Vorrichtung zur elektrischen und mechanischen Verbindung von zwei nebeneinander angeordneten Leiterplatten zu schaffen.

Diese Aufgabe wird gelöst durch eine Verbindungsvorrichtung mit den Merkmalen des Anspruchs 1. Vorteilhafte Ausgestaltungen und Weiterbildungen der Erfindung sind Gegenstand der abhängigen Ansprüche.

Die erfindungsgemäße Vorrichtung dient zur elektrischen und mechanischen Verbindung von zwei nebeneinander angeordneten Leiterplatten, wobei eine erste Leiterplatte auf einer ersten Seite wenigstens eine erste Kontaktfläche aufweist und eine zweite Leiterplatte auf einer ersten Seite wenigstens eine erste Kontaktfläche aufweist. Die Verbindungsvorrichtung ist gemäß der Erfindung dadurch gekennzeichnet, dass sie eine erste Trägerplatte auf der den ersten Seiten der beiden Leiterplatten zugewandten Seite und eine zweite Trägerplatte auf der den zweiten Seiten der beiden Leiterplatten zugewandten Seite aufweist, wobei die erste und/oder die zweite Trägerplatte zumindest teilweise aus einem elektrisch isolierenden Material bestehen; die erste Trägerplatte auf ihrer den beiden Leiterplatten zugewandten Seite wenigstens eine Kontaktfläche aus einem elektrisch leitfähigen Material aufweist; und sie eine Spannvorrichtung aufweist, um die erste und die zweite Trägerplatte mit zumindest Endbereichen der beiden Leiterplatten dazwischen derart zu verbinden, dass die wenigstens eine Kontaktfläche der ersten Trägerplatte sowohl mit der wenigstens einen ersten Kontaktfläche der ersten Leiterplatte als auch mit der wenigstens einen ersten Kontaktfläche der zweiten Leiterplatte in Kontakt ist.

Mit der erfindungsgemäßen Verbindungsvorrichtung erfolgt eine elektrische Verbindung zwischen den Kontaktflächen der beiden benachbarten Leiterplatten allein durch die Kontaktfläche an der Trägerplatte. Es existieren somit lediglich zwei Übergangswiderstände an den beiden Verbindungen zwischen dieser Trägerplatten-Kontaktfläche und der jeweiligen Kontaktfläche der beiden Leiterplatten. Diese Verbindungsvorrichtung ist damit insbesondere auch für hohe Spannungen und/oder große Ströme geeignet.

Außerdem hat die Verbindungsvorrichtung gemäß der Erfindung einen einfachen Aufbau, insbesondere einen einfachen Aufbau aus wenigen und einfachen Komponenten.

Die elektrische Verbindung und zugleich auch die mechanische Verbindung zwischen den beiden nebeneinander angeordneten Leiterplatten erfolgt durch das Anordnen der Endbereiche der beiden Leiterplatten zwischen zwei Trägerplatten und Verspannen dieser Anordnung in Richtung quer zu den Ebenen der beiden Leiterplatten. Mit Hilfe der erfindungsgemäßen Verbindungsvorrichtung lässt sich auf einfache Weise eine stabile Verbindung zwischen den benachbarten Leiterplatten erzielen.

Ferner ist auch der Verbindungsvorgang von zwei Leiterplatten mit Hilfe der erfindungsgemäßen Verbindungsvorrichtung einfach und mit wenigen Schritten durchzuführen.

Der Begriff "Leiterplatte" umfasst in diesem Zusammenhang allgemein einen Träger für elektronische Bauteile, der sowohl der mechanischen Befestigung als auch der elektrischen Verbindung dient. Für eine Leiterplatte werden auch die Begriffe Leiterkarte, Platine und gedruckte Schaltung (engl. printed circuit board) verwendet.

Die Verbindung von "zwei Leiterplatten" umfasst in diesem Zusammenhang die Verbindung wenigstens einer ersten Leiterplatte mit wenigstens einer zweiten Leiterplatte. Neben der Verbindung von genau einer ersten Leiterplatte mit genau einer zweiten Leiterplatte können mit Hilfe der erfindungsgemäßen Verbindungsvorrichtungen auch mehrere erste Leiterplatten gleichzeitig mit einer zweiten Leiterplatte, eine erste Leiterplatte gleichzeitig mit mehreren zweiten Leiterplatten und mehrere erste Leiterplatten gleichzeitig mit mehreren zweiten Leiterplatten verbunden werden. Die mehreren ersten bzw. zweiten Leiterplatten sind in diesem Fall vorzugsweise im Wesentlichen koplanar zueinander ausgerichtet und in Richtung quer zur Verbindungsrichtung nebeneinander angeordnet.

Die zu verbindenden Leiterplatten sind nicht notwendigerweise gleich dick (in Richtung quer zur Verbindungsrichtung).

Die Anordnung der zwei zu verbindenden Leiterplatten "nebeneinander" soll alle Anordnungen umfassen, bei denen die schmalen Stirnseiten der benachbarten Leiterplatten einander zugewandt sind. Dabei umfasst der Begriff "nebeneinander" in diesem Zusammenhang sowohl im Wesentlichen koplanare Anordnungen der Leiterplatten als auch im Winkel zueinander stehende Leiterplatten. Der Verbindungswinkel liegt dabei vorzugsweise im Bereich von 0 Grad (koplanar) bis etwa 90 Grad (senkrecht), ohne dass die Erfindung auf diesen Wertebereich beschränkt sein soll.

Unter dem Begriff "Kontaktfläche" einer Leiterplatte soll in diesem Zusammenhang eine Fläche an einer Hauptseite der Leiterplatte verstanden werden, die elektrisch leitfähig ausgebildet ist. Eine solche Kontaktfläche ist üblicherweise mit einer oder mehreren Leiterbahnen in/auf der Leiterplatte verbunden. Eine solche Kontaktfläche dient im Allgemeinen der elektrisch leitfähigen Montage von elektronischen Bauteilen auf der Leiterplatte. Die Befestigung der Bauteile erfolgt dabei zumeist mittels eines Lötverfahrens, die Kontaktflächen werden deshalb häufig auch als Lötflächen oder Lötpads bezeichnet. Die Kontaktflächen bestehen vorzugsweise aus Kupfer oder verzinntem Kupfer. Die Kontaktflächen der Leiterplatten in deren End- oder Kantenbereich können auch als Kantenkontakte bezeichnet werden.

Die "Trägerplatte" ist ein plattenförmiger Körper von grundsätzlich beliebiger Grundform (z.B. Quadrat, Rechteck, Kreis, Ellipsoid, etc.). Die erste und die zweite Trägerplatte der Verbindungsvorrichtung sind vorzugsweise elektrisch isolierend ausgebildet. Die beiden Trägerplatten besitzen vorzugsweise eine ausreichende mechanische Festigkeit, um bei dem Verbindungsvorgang mittels der Spannvorrichtung die mechanische und elektrische Verbindung der nebeneinander angeordneten Leiterplatten zu gewährleisten. Die Trägerplatten sind vorzugsweise so dimensioniert, dass sie die einander zugewandten Endbereiche der benachbarten Leiterplatten mit den Kontaktflächen überdecken und auch einen etwaigen Abstand (sofern vorhanden) zwischen den benachbarten Leiterplatten überbrücken. Ferner sind die Trägerplatten vorzugsweise so dimensioniert, dass sie quer zur Verbindungsrichtung alle Kontaktflächen der ersten Leiterplatte und alle Kontaktflächen der zweiten Leiterplatte, die mittels der Verbindungsvorrichtung elektrisch miteinander verbunden werden sollen, überdecken. Grundsätzlich können die Trägerplatten auch im Wesentlichen die gleiche Breite wie die beiden Leiterplatten haben. Im Fall einer winkligen Ausrichtung der nebeneinander angeordneten Leiterplatten sind die beiden Trägerplatten der Verbindungsvorrichtung ebenfalls winklig ausgebildet. Der Winkel der Trägerplatten entspricht vorzugsweise im Wesentlichen dem Verbindungswinkel zwischen den beiden Leiterplatten. Der Winkel der ersten Trägerplatte entspricht vorzugsweise im Wesentlichen dem Winkel der zweiten Trägerplatte.

Unter dem Begriff "Kontaktfläche" der Trägerplatte soll in diesem Zusammenhang eine Fläche an einer Hauptseite der Trägerplatte aus einem elektrisch leitfähigen Material (z.B. Metall) verstanden werden. Die Form und die Dicke dieser Kontaktfläche sind grundsätzlich beliebig, sofern sie eine elektrisch leitende Verbindung zwischen den Kontaktflächen der Leiterplatten gewährleisten.

Bei einpoligen Verbindungen zwischen den Leiterplatten und einem isolierenden Gehäuse für die Leiterplatten muss zumindest eine der zwei Trägerplatten der Verbindungsvorrichtung nicht elektrisch isolierend sein, d.h. Trägerplatte und Kontaktfläche der Trägerplatte bilden eine Einheit und können aus dem gleichen Material gefertigt sein. Im Fall des Erdleiteranschlusses und eines geerdeten (metallischen) Gehäuses stellt dann vorzugsweise die Spannvorrichtung der Verbindungsvorrichtung auch die elektrische Verbindung zu mindestens einer Kontaktfläche der Leiterplatten bzw. jeder Leiterplatte her.

Der Begriff "Spannvorrichtung" soll in Zusammenhang mit der vorliegenden Erfindung jede Art von Vorrichtung umfassen, die geeignet ist, die zwei Trägerplatten der Verbindungsvorrichtung mit den Endbereichen der beiden benachbarten Leiterplatten dazwischen ausreichend fest miteinander zu verbinden, dass eine elektrische und mechanische Verbindung der beiden Leiterplatten erreicht ist. Die Spannvorrichtung ist vorzugsweise so ausgebildet, dass sie im gelösten Betriebszustand das Einfügen der Endbereiche der Leiterplatten zwischen die beiden Trägerplatten der Verbindungsvorrichtung erlaubt und im angezogenen Betriebszustand einen festen Verbund der Leiterplatten mit der Verbindungsvorrichtung bildet. Die Spannvorrichtung verspannt die beiden Trägerplatten der Verbindungsvorrichtung mit den Endbereichen der ersten Leiterplatte dazwischen in einer Richtung im Wesentlichen quer zur Ebene der ersten Leiterplatte und die beiden Trägerplatten der Verbindungsvorrichtung mit den Endbereichen der zweiten Leiterplatte dazwischen in einer Richtung im Wesentlichen quer zur Ebene der zweiten Leiterplatte. Im Fall einer winkligen Ausrichtung der beiden Leiterplatten zueinander erfolgen die vorgenannten Verspannungen entsprechend in unterschiedlichen Raumrichtungen. Sie Spannvorrichtung dient in diesem Zusammenhang hauptsächlich der mechanischen Verbindung der benachbarten Leiterplatten. Zusätzlich kann die Spannvorrichtung auch eine mechanische Befestigung der verbundenen Leiterplatten an einem Gehäuse oder dergleichen bewirken.

In einer vorteilhaften Ausgestaltung der Erfindung weist auch die zweite Trägerplatte auf ihrer den beiden Leiterplatten zugewandten Seite wenigstens eine Kontaktfläche aus einem elektrisch leitfähigen Material auf. In diesem Fall ist die Spannvorrichtung auch so ausgebildet, dass sie die erste und die zweite Trägerplatte mit zumindest Endbereichen der beiden Leiterplatten dazwischen derart verbindet, dass die wenigstens eine Kontaktfläche der zweiten Trägerplatte sowohl mit wenigstens einer zweiten Kontaktfläche auf einer der ersten Seite abgewandten zweiten Seite der ersten Leiterplatte als auch mit wenigstens einer zweiten Kontaktfläche auf einer der ersten Seite abgewandten zweiten Seite der zweiten Leiterplatte in Kontakt ist. Bei dieser Ausführungsform können koplanar zueinander angeordnete Leiterplatten in zwei Ebenen (erste Kontaktflächen der Leiterplatten und zweite Kontaktflächen der Leiterplatten) elektrisch miteinander verbunden werden. Die Anwendungsmöglichkeiten der erfindungsgemäßen Verbindungsvorrichtung werden so erweitert.

Grundsätzlich sind aber auch Verbindungsvorrichtungen von dieser Erfindung erfasst, mit denen die benachbarten Leiterplatten nur auf einer Seite (erste Kontaktflächen der Leiterplatten) elektrisch miteinander verbunden werden und die zweite Trägerplatte der Verbindungsvorrichtung lediglich als mechanische Stütze dient. Andererseits können aber auch die Verbindungsvorrichtungen, bei denen auch die zweite Trägerplatte mit einer elektrisch leitenden Kontaktfläche versehen ist, zur koplanaren Verbindung von Leiterplatten verwendet werden, die nur auf einer Seite Kontaktflächen aufweisen.

In einer vorteilhaften Ausgestaltung der Erfindung weist die erste Trägerplatte mehrere elektrisch voneinander isolierte Kontaktflächen zum Verbinden mehrerer voneinander isolierter erster Kontaktflächen der ersten Leiterplatte mit mehreren voneinander isolierten ersten Kontaktflächen der zweiten Leiterplatte auf und/oder weist die zweite Trägerplatte mehrere elektrisch voneinander isolierte Kontaktflächen zum Verbinden mehrerer voneinander isolierter zweiter Kontaktflächen der ersten Leiterplatte mit mehreren voneinander isolierten zweiten Kontaktflächen der zweiten Leiterplatte auf. Die Kontaktflächen der Verbindungsvorrichtung sind in diesem Fall zum Beispiel streifenförmig ausgebildet und zueinander beabstandet an den Trägerplatten vorgesehen.

Mit Hilfe der Verbindungsvorrichtung der Erfindung können in vorteilhafter Weise auch galvanisch getrennte Potentiale zwischen den benachbarten Leiterplatten übertragen werden.

In einer weiteren vorteilhaften Ausgestaltung der Erfindung ist die wenigstens eine Kontaktfläche der ersten Trägerplatte zumindest in einem ihrer den ersten Kontaktflächen der beiden Leiterplatten zugewandten Bereiche zumindest teilweise mit einer strukturierten Oberfläche versehen und/oder ist die wenigstens eine Kontaktfläche der zweiten Trägerplatte zumindest in einem ihrer den zweiten Kontaktflächen der beiden Leiterplatten zugewandten Bereiche zumindest teilweise mit einer strukturierten Oberfläche versehen. Die strukturierte Oberfläche ist vorzugsweise eine Aufrauung, Riffelung oder dergleichen.

In einer weiteren vorteilhaften Ausgestaltung der Erfindung ist die wenigstens eine Kontaktfläche der ersten Trägerplatte zumindest in einem ihrer den ersten Kontaktflächen der beiden Leiterplatten zugewandten Bereiche aus einem Material mit einer höheren Härte als das Material der ersten Kontaktflächen der beiden Leiterplatten gebildet und/oder ist die wenigstens eine Kontaktfläche der zweiten Trägerplatte zumindest in einem ihrer den zweiten Kontaktflächen der beiden Leiterplatten zugewandten Bereiche aus einem Material mit einer höheren Härte als das Material der zweiten Kontaktflächen der beiden Leiterplatten gebildet.

Bei Ausführungsformen, bei welchen die beiden vorgenannten Maßnahmen gemeinsam vorgesehen sind, kann sich die strukturierte Kontaktfläche der Trägerplatte in die jeweilige Kontaktfläche der Leiterplatte eindrücken. Auf diese Weise können eine größere Kontaktierungsfläche und als Ergebnis ein extrem kleiner Übergangswiderstand erzielt werden, was zu einer Erhöhung der Stromtragfähigkeit der Verbindung führt.

In einer noch weiteren Ausgestaltung der Erfindung weist die Vorrichtung ferner wenigstens eine Positioniereinrichtung zum richtigen Positionieren der Vorrichtung relativ zu den beiden Leiterplatten auf. Die Positioniereinrichtung weist vorzugsweise Vorsprünge, Marken, Zähne, Rippen, Federn oder dergleichen auf, die in entsprechende Ausnehmungen, Nuten oder dergleichen in den Leiterplatten eingreifen können, oder umgekehrt. Die Positioniereinrichtung kann auch eine optische Positionierhilfe aufweisen. Weiter ist die Positioniereinrichtung vorzugsweise für beide zu verbindende Leiterplatten vorgesehen. Die Positioniereinrichtung dient vorzugsweise auch als Kodierung, um für bestimmte Leiterplatten die entsprechende Verbindungsvorrichtung auszuwählen und einzusetzen.

In einer noch weiteren Ausgestaltung der Erfindung weist die Vorrichtung ferner wenigstens eine Positionshalteeinrichtung zum Beibehalten einer richtigen Positionierung der Vorrichtung relativ zu den beiden Leiterplatten während eines Montagevorganges der Vorrichtung auf. Die Positionshalteeinrichtung ist vorzugsweise als Verdrehsicherung ausgestaltet.

In einer vorteilhaften Ausgestaltung der Erfindung weist die Spannvorrichtung wenigstens eine Schraube auf, die durch entsprechende Durchgangsbohrungen in den beiden Trägerplatten geführt ist. Die Schraubverbindung stellt eine besonders einfache Montage der erfindungsgemäßen Verbindungsvorrichtung bereit. Grundsätzlich ist eine einzige Schraube für die Spannvorrichtung ausreichend, mit dem Vorteil einer schnellen Montage, insbesondere bei ausgedehnten Trägerplatten können aber auch zwei oder mehr Schrauben für die Spannvorrichtung vorgesehen sein.

Bei dieser Konfiguration der Spannvorrichtung weist die Vorrichtung vorzugsweise ferner wenigstens ein Isolierelement auf, das zumindest teilweise aus einem elektrisch isolierenden Material besteht und das entsprechend den Durchgangsbohrungen in den Trägerplatten angeordnet ist, um die wenigstens eine Schraube gegen die wenigstens eine Kontaktfläche der ersten Trägerplatte und/oder die wenigstens eine Kontaktfläche der zweiten Trägerplatte zu isolieren.

Alternativ oder zusätzlich kann die Spannvorrichtung auch Klemmen, Nieten oder dergleichen aufweisen, welche die beiden Trägerplatten der Verbindungsvorrichtung an ihren Außenumfängen umgreifen.

In einer weiteren vorteilhaften Ausgestaltung der Erfindung weist die Vorrichtung wenigstens eine Abstandseinrichtung zum richtigen Beabstanden der beiden Leiterplatten zueinander auf. Vorzugsweise vergrößert diese Abstandseinrichtung auch die Luft- und Kriechstrecke zwischen den Trägerplatten der Verbindungsvorrichtung sowie zwischen den zu verbindenden Leiterplatten. Dies kann insbesondere von Vorteil sein, wenn die Trägerplatten außerhalb ihrer Kontaktflächen nicht elektrisch isolierend ausgebildet oder elektrisch isoliert sind.

Die Positioniereinrichtung, die Positionshalteeinrichtung, die Isolierelemente und die Abstandseinrichtung können wahlweise als verschiedene Komponenten konzipiert sein oder in Zweier- oder Mehrfachkombinationen als eine Einheit bzw. ein Bauteil ausgebildet sein. In einer vorteilhaften Ausgestaltung der Erfindung können die Positioniereinrichtung, die Positionshalteeinrichtung, die Isolierelemente und/oder die Abstandseinrichtung auch integral mit den Trägerplatten der Verbindungsvorrichtung ausgebildet sein.

Die Verbindungsvorrichtung der Erfindung kann in vorteilhafter Weise zum Verbinden von zwei koplanaren Leiterplatten in einem Solarwechselrichter eingesetzt werden, um eine kostengünstige Verbindung für hohe Spannungen (z.B. 1 kV) und große Ströme (typischerweise mehr als 10 A) zu erzielen, ohne dass die vorliegende Erfindung jedoch auf diese Anwendung beschränkt sein soll.

Selbstverständlich können mit Hilfe der erfindungsgemäßen Verbindungsvorrichtungen auch mehr als zwei Leiterplatten elektrisch und mechanisch miteinander verbunden werden.

Die erfindungsgemäße Verbindungsvorrichtung kann grundsätzlich auch eingesetzt werden, um eine Leiterplatte elektrisch und mechanisch an einen Träger, eine Montageplattform oder dergleichen mit entsprechenden Kontaktflächen anzuschließen. Im Sinne der vorliegenden Erfindung soll deshalb ein solcher Träger oder dergleichen auch als zweite Leiterplatte verstanden werden.

Obige sowie weitere Merkmale und Vorteile der Erfindung werden aus der nachfolgenden Beschreibung von bevorzugten, nicht-einschränkenden Ausführungsbeispielen unter Bezugnahme auf die beiliegenden Zeichnungen besser verständlich. Darin zeigen:
- Fig. 1: eine schematische Schnittansicht eines ersten Ausführungsbeispiels einer erfindungsgemäßen Verbindungsvorrichtung; und
- Fig. 2: eine schematische Schnittansicht eines zweiten Ausführungsbeispiels einer erfindungsgemäßen Verbindungsvorrichtung.

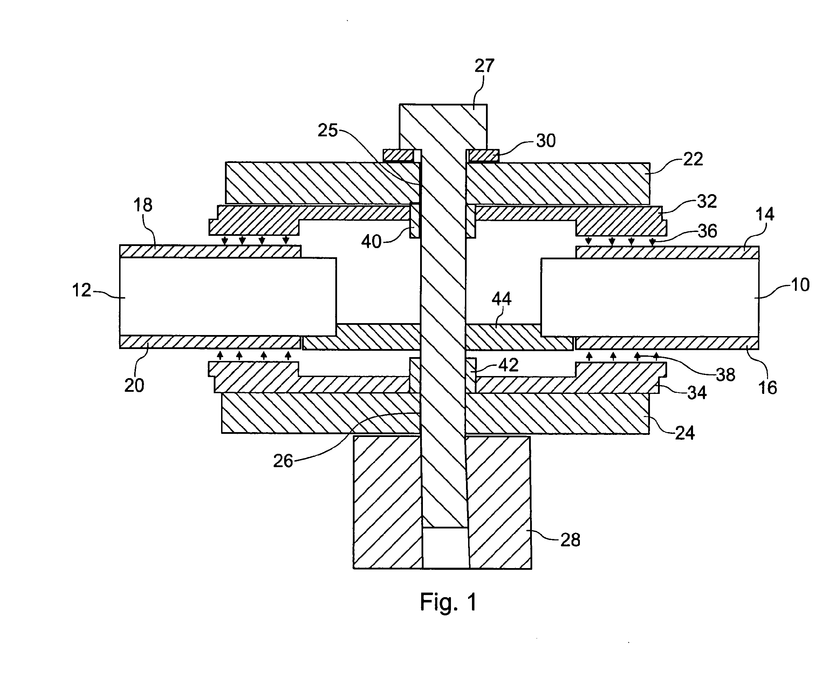

Anhand von Figur 1 wird zunächst ein erstes Ausführungsbeispiel einer Verbindungsvorrichtung beschrieben, welches zum mechanischen und elektrischen Verbinden von zwei im Wesentlichen koplanar zueinander angeordneten Leiterplatten geeignet ist.

Figur 1 zeigt die einander zugewandten Endbereich von zwei benachbarten Leiterplatten 10 und 12, die im Wesentlichen koplanar zueinander angeordnet sind. In dem Ausführungsbeispiel sind die beiden Leiterplatten 10, 12 voneinander beabstandet; dieser Abstand kann auch kleiner oder größer sein oder entfallen.

Die erste Leiterplatte 10 hat auf ihrer ersten Seite (oben in Figur 1) wenigstens eine erste Kontaktfläche 14 und auf ihrer zweiten Seite (unten in Figur 1) wenigstens eine zweite Kontaktfläche 16. In ähnlicher Weise hat auch die zweite Leiterplatte 12 auf ihrer ersten Seite (oben in Figur 1) wenigstens eine erste Kontaktfläche 18 und auf ihrer zweiten Seite (unten in Figur 1) wenigstens eine zweite Kontaktfläche 20. Die ersten und zweiten Kontaktflächen 14-20 der beiden Leiterplatten 10, 12 bestehen zum Beispiel aus blankem Kupfer oder metallisierten Kontakten (verzinnt, vergoldet, ...).

Die beiden Leiterplatten 10, 12 mit ihren Kontaktflächen 14-20 in ihren einander zugewandten Endbereichen werden mit Hilfe einer Verbindungsvorrichtung elektrisch und mechanisch miteinander verbunden.

Diese Verbindungsvorrichtung weist eine erste Trägerplatte 22 und eine zweite Trägerplatte 24 auf, wobei die beiden Trägerplatten 22, 24 im Wesentlichen parallel zueinander und im Wesentlichen parallel zu den beiden Leiterplatten 10, 12 ausgerichtet sind. Die beiden Trägerplatten 22, 24 bestehen vorzugsweise aus einem elektrisch isolierenden, steifen Material.

Im Bereich zwischen den beiden Leiterplatten 10, 12 sind die beiden Trägerplatten 22, 24 der Verbindungsvorrichtung jeweils mit einer Durchgangsbohrung 25 bzw. 26 versehen, wobei diese Durchgangsbohrungen im Wesentlichen koaxial zueinander ausgebildet sind. Durch diese Durchgangsbohrungen 25 und 26 der beiden Trägerplatten 22, 24 ist quer zur Verbindungsrichtung bzw. zur Ebene der Leiterplatten 10, 12 (d.h. in Oben/Unten-Richtung in Figur 1) eine Schraube 27 geführt. Der Schraubenkopf der Schraube 27 stützt sich über eine Tellerscheibe, eine Unterlegscheibe 30, einen Zahnring, einen Federring oder dergleichen an der ersten Trägerplatte 22 ab, während das Gewinde der Schraube 27 in ein Gewinde in einem Bodenteil 28 (z.B. in der Art einer Schraubenmutter oder als Teil eines Gerätegehäuses ausgebildet) eingreift, auf dem sich die zweite Trägerplatte 24 abstützt. Alternativ kann das Gewinde, in welches die Spannschraube 27 eingreift, auch in der zweiten Trägerplatte 24 selbst ausgebildet sein.

Die Schraube 27 und das Bodenteil 28 bilden die Spannvorrichtung der Verbindungsvorrichtung Beim Anziehen der Schraube 27 werden die beiden Trägerplatten 22, 24 aufeinander zu bewegt und damit jeweils auch in Richtung auf die zwischengesetzten Endbereiche der beiden Leiterplatten 10, 12 zu bewegt.

An der den Leiterplatten zugewandten Unterseite der ersten Trägerplatte 22 ist (entsprechend der Anzahl der ersten Kontaktflächen 14, 18 der Leiterplatten 10, 12) wenigstens eine Kontaktfläche 32 vorgesehen. Diese Kontaktfläche 32 ist elektrisch leitend und ist zum Beispiel aus Metall gefertigt. Da in dem Ausführungsbeispiel von Figur 1 an den Leiterplatten 10, 12 auch zweite Kontaktflächen 16, 20 vorgesehen sind, ist auch an der den Leiterplatten zugewandten oberen Seite der zweiten Trägerplatte 24 (entsprechend der Anzahl der zweiten Kontaktflächen 16, 20 der Leiterplatten 10, 12) wenigstens eine Kontaktfläche 34 vorgesehen. Diese Kontaktfläche 34 ist ebenfalls elektrisch leitend und zum Beispiel aus Metall gefertigt.

Vorzugsweise sind die Endbereiche der Kontaktflächen 32, 34 an den Trägerplatten 22, 24, welche die ersten bzw. zweiten Kontaktflächen 14 - 20 der Leiterplatten 10, 12 kontaktieren sollen, strukturiert ausgebildet (z.B. aufgeraut) 36, 38. Außerdem sind die Kontaktflächen 32, 34 an den Trägerplatten 22, 24 vorzugsweise aus einem härteren Material gefertigt als die Kontaktflächen 14 - 20 der Leiterplatten 10, 12. Wenn die Schraube 27 angezogen wird, werden die Trägerplatten 22, 24 und damit auch deren Kontaktflächen 32, 34 gegen die Endbereiche der Leiterplatten 10, 12 gedrückt, sodass die Oberflächenstrukturen 36, 38 der härteren Kontaktflächen 32, 34 an den Trägerplatten 22, 24 in die weicheren Kontaktflächen 14 - 20 der Leiterplatten 10, 12 eindringen. Dies führt zu einer großflächigeren und sichereren Kontaktierung und damit zu einer Reduzierung der Übergangswiderstände an diesen Verbindungsstellen, was die Stromtragfähigkeit aufgrund des verringerten Übergangswiderstandes erhöht.

In dem Ausführungsbeispiel von Figur 1 sind die Kontaktflächen 32, 34 an den Trägerplatten 22, 24 in ihren Endbereichen gestuft ausgebildet. Die Kontaktflächen 32, 34 können aber ebenso im Wesentlichen plan ausgebildet sein.

Um eine elektrische Kontaktierung der Schraube 27 durch die Kontaktflächen 32, 34 an den Trägerplatten 22, 24 zu verhindern, sind an den Trägerplatten 22, 24 im Bereich der Durchgangsbohrungen 25, 26 vorzugsweise kragen- bzw. hülsenförmige Isolierelemente 40, 42 aus einem elektrisch isolierenden Material angebracht oder angeformt.

Wie in Figur 1 dargestellt, ist ferner ein Positionierelement 44 vorgesehen. Dieses ist an der Verbindungsvorrichtung zwischen den beiden Leiterplatten 10, 12 angeordnet und zum Beispiel über das Isolierelement 42 mit der zweiten Trägerplatte 24 verbunden.

Dieses Positionierelement 44 dient einerseits als Positionierhilfe, indem es mit Vorsprüngen in entsprechende Nuten in den Leiterplatten 10, 12 eingreift, um die Verbindungsvorrichtung relativ zu den Leiterplatten 10, 12 so zu positionieren, dass die gewünschte(n) elektrische(n) Verbindung(en) zwischen den beiden Leiterplatten 10, 12 hergestellt werden. Mit Hilfe des Positionierelements 44 erfolgt auch eine Art Kodierung der Verbindungsvorrichtung, sodass für vorgegebene Leiterplatten 10, 12 mit bestimmten Anzahlen und Anordnungen von Kontaktflächen 14 - 20 jeweils die richtige Verbindungsvorrichtung mit passenden Kontaktflächen 32, 34 ausgewählt wird.

Zudem dient dieses Positionierelement 44 als Abstandshalter zwischen den beiden Leiterplatten 10, 12 auf das richtige Maß, um die gewünschte(n) elektrische(n) Verbindung(en) zwischen den beiden Leiterplatten 10, 12 zu erzielen. Schließlich dient dieses Positionierelement 44 auch als Verdrehsicherung, um die richtige Positionierung der Verbindungsvorrichtung relativ zu den beiden Leiterplatten 10, 12 während des Montageprozesses, insbesondere während des Anziehens der einen Schraube 27 aufrechtzuerhalten.

Obwohl in Figur 1 nicht dargestellt, ist vorzugsweise ein weiteres solches Positionierelement vorgesehen, welches über das Isolierelement 40 mit der oberen Trägerplatte 22 der Verbindungsvorrichtung fest verbunden ist.

Diese beiden Positionierelemente bilden die Positioniereinrichtung, die Positionshalteeinrichtung und die Abstandseinrichtung im Sinne der Erfindung.

In einer alternativen Ausgestaltung können die Positionierelemente 44 auch direkt durch die Isolierelemente 40, 42 oder integral mit diesen ausgebildet sein.

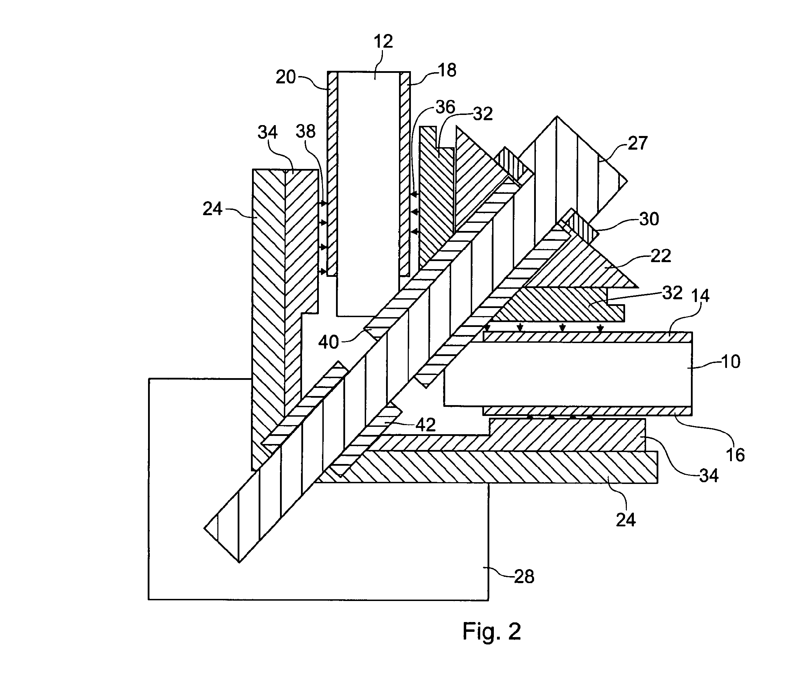

Anhand von Figur 2 wird nun ein zweites Ausführungsbeispiel einer Verbindungsvorrichtung beschrieben, welches zum mechanischen und elektrischen Verbinden von zwei im Wesentlichen orthogonal zueinander angeordneten Leiterplatten (als Beispiel für im Winkel zueinander ausgerichtete Leiterplatten) geeignet ist. Gleiche und entsprechende Komponenten sind dabei mit den gleichen Bezugsziffern wie im ersten Ausführungsbeispiel gekennzeichnet.

In diesem Ausführungsbeispiel stehen die beiden benachbarten Leiterplatten 10 und 12 im Wesentlichen senkrecht zueinander. Um diese beiden Leiterplatten 10, 12 mechanisch und elektrisch miteinander verbinden zu können, sind die beiden Trägerplatten 22 und 24 der Verbindungsvorrichtung ebenfalls im Wesentlichen rechtwinklig ausgebildet.

Die Spannschraube 27 verläuft in einem Winkel von etwa 45° zur ersten Leiterplatte 10 und zur zweiten Leiterplatte 12 und verläuft durch die Ecken der beiden Trägerplatten 22, 24. Das Isolierelement 40 der ersten Trägerplatte 22 ist dabei so weit in Richtung zur zweiten Trägerplatte 24 geführt, dass es sich in den Zwischenraum zwischen den beiden Leiterplatten 10, 12 erstreckt und damit auch die beiden Leiterplatten 10, 12 bzw. deren Kontaktflächen 14 - 20 elektrisch voneinander isoliert. Alternativ kann auch das Isolierelement 42 an der zweiten Trägerplatte 24 in Richtung zur ersten Trägerplatte 22 entsprechend verlängert sein oder können die beiden Isolierelemente 40 und 42 einstückig miteinander ausgebildet sein.

Bei gelöster Spannschraube 27 können die Endbereiche der beiden Leiterplatten 10, 12 mit ihren Kontaktflächen 14 - 20 zwischen die Trägerplatten 22, 24 mit ihren Kontaktflächen 32, 34 eingeschoben werden. Wird dann die Schraube 27 angezogen, so werden die beiden Trägerplatten 22, 24 derart miteinander verspannt, dass einerseits der Endbereich der ersten Leiterplatte 10 zwischen den beiden Trägerplatten 22, 24 festgeklemmt wird und gleichzeitig ein elektrischer Kontakt zwischen den Kontaktflächen 14, 16 der ersten Leiterplatte 10 und den Kontaktflächen 32, 34 der beiden Trägerplatten 22, 24 hergestellt wird und andererseits der Endbereich der zweiten Leiterplatte 12 zwischen den beiden Trägerplatten 22, 24 festgeklemmt wird und gleichzeitig ein elektrischer Kontakt zwischen den Kontaktflächen 18, 20 der zweiten Leiterplatte 12 und den Kontaktflächen 32, 34 der beiden Trägerplatten 22, 24 hergestellt wird. Das Einspannen der Leiterplatten 10, 12 erfolgt dabei jeweils im Wesentlichen senkrecht zur jeweiligen Leiterplattenebene.

Im Übrigen entspricht die Verbindungsvorrichtung des zweiten Ausführungsbeispiels der in Fig. 1 dargestellten Verbindungsvorrichtung. Auf eine wiederholte Beschreibung der übrigen Komponenten, Funktionen und Alternativen wird daher an dieser Stelle verzichtet.

Fig. 2 zeigt beispielhaft eine Verbindungsvorrichtung zum Verbinden von zwei Leiterplatten, die im Wesentlichen senkrecht zueinander ausgerichtet sind. Es sind ebenso Verbindungsvorrichtung möglich, mit denen Leiterplatten elektrisch und mechanisch miteinander verbunden werden können, die in einem Winkel von kleiner 90 Grad oder größer 90 Grad zueinander angeordnet sind.

### BEZUGSZIFFERNLISTE

- 10: erste Leiterplatte
- 12: zweite Leiterplatte
- 14: erste Kontaktfläche der ersten Leiterplatte
- 16: zweite Kontaktfläche der ersten Leiterplatte
- 18: erste Kontaktfläche der zweiten Leiterplatte
- 20: zweite Kontaktfläche der zweiten Leiterplatte
- 22: erste Trägerplatte
- 24: zweite Trägerplatte
- 25: Durchgangsbohrung in erster Trägerplatte
- 26: Durchgangsbohrung in zweiter Trägerplatte
- 27: Schraube
- 28: Bodenteil mit Gewinde
- 30: Unterlegscheibe
- 32: Kontaktfläche der ersten Trägerplatte
- 34: Kontaktfläche der zweiten Trägerplatte
- 36: Oberflächenstruktur
- 38: Oberflächenstruktur
- 40: Isolierelement
- 42: Isolierelement
- 44: Positionierelement

## Patentansprüche

1. Vorrichtung zur elektrischen und mechanischen Verbindung von zwei nebeneinander angeordneten Leiterplatten (10, 12), wobei eine erste Leiterplatte (10) auf einer ersten Seite wenigstens eine erste Kontaktfläche (14) aufweist und eine zweite Leiterplatte (12) auf einer ersten Seite wenigstens eine erste Kontaktfläche (18) aufweist,
**dadurch gekennzeichnet, dass**
die Vorrichtung eine erste Trägerplatte (22) auf der den ersten Seiten der beiden Leiterplatten (10, 12) zugewandten Seite und eine zweite Trägerplatte (24) auf der den zweiten Seiten der beiden Leiterplatten (10, 12) zugewandten Seite aufweist, wobei die erste und/oder die zweite Trägerplatte (22, 24) zumindest teilweise aus einem elektrisch isolierenden Material bestehen;
die erste Trägerplatte (22) auf ihrer den beiden Leiterplatten (10, 12) zugewandten Seite wenigstens eine Kontaktfläche (32) aus einem elektrisch leitfähigen Material aufweist; und
die Vorrichtung eine Spannvorrichtung (27, 28) aufweist, um die erste und die zweite Trägerplatte (22, 24) mit zumindest Endbereichen der beiden Leiterplatten (10, 12) dazwischen derart zu verbinden, dass die wenigstens eine Kontaktfläche (32) der ersten Trägerplatte (22) sowohl mit der wenigstens einen ersten Kontaktfläche (14) der ersten Leiterplatte (10) als auch mit der wenigstens einen ersten Kontaktfläche (18) der zweiten Leiterplatte (12) in Kontakt ist.

2. Verbindungsvorrichtung nach Anspruch 1,
**dadurch gekennzeichnet, dass**
die zweite Trägerplatte (24) auf ihrer den beiden Leiterplatten (10, 12) zugewandten Seite wenigstens eine Kontaktfläche (34) aus einem elektrisch leitfähigen Material aufweist; und
die Spannvorrichtung (27, 28) die erste und die zweite Trägerplatte (22, 24) mit zumindest Endbereichen der beiden Leiterplatten (10, 12) dazwischen derart verbindet, dass die wenigstens eine Kontaktfläche (34) der zweiten Trägerplatte (24) sowohl mit wenigstens einer zweiten Kontaktfläche (16) auf einer der ersten Seite abgewandten zweiten Seite der ersten Leiterplatte (10) als auch mit wenigstens einer zweiten Kontaktfläche (20) auf einer der ersten Seite abgewandten zweiten Seite der zweiten Leiterplatte (12) in Kontakt ist.

3. Verbindungsvorrichtung nach einem der vorhergehenden Ansprüche, **dadurch gekennzeichnet, dass**
die erste Trägerplatte (22) mehrere elektrisch voneinander isolierte Kontaktflächen (32) zum Verbinden mehrerer voneinander isolierter erster Kontaktflächen (14) der ersten Leiterplatte (10) mit mehreren voneinander isolierten ersten Kontaktflächen (18) der zweiten Leiterplatte (12) aufweist und/oder die zweite Trägerplatte (24) mehrere elektrisch voneinander isolierte Kontaktflächen (34) zum Verbinden mehrerer voneinander isolierter zweiter Kontaktflächen (16) der ersten Leiterplatte (10) mit mehreren voneinander isolierten zweiten Kontaktflächen (20) der zweiten Leiterplatte (12) aufweist.

4. Verbindungsvorrichtung nach einem der vorhergehenden Ansprüche, **dadurch gekennzeichnet, dass**
die wenigstens eine Kontaktfläche (32) der ersten Trägerplatte (22) zumindest in einem ihrer den ersten Kontaktflächen (14, 18) der beiden Leiterplatten (10, 12) zugewandten Bereiche zumindest teilweise mit einer strukturierten Oberfläche (36) versehen ist und/oder die wenigstens eine Kontaktfläche (34) der zweiten Trägerplatte (24) zumindest in einem ihrer den zweiten Kontaktflächen (16, 20) der beiden Leiterplatten (10, 12) zugewandten Bereiche zumindest teilweise mit einer strukturierten Oberfläche (38) versehen ist.

5. Verbindungsvorrichtung nach einem der vorhergehenden Ansprüche, **dadurch gekennzeichnet, dass**
die wenigstens eine Kontaktfläche (32) der ersten Trägerplatte (22) zumindest in einem ihrer den ersten Kontaktflächen (14, 18) der beiden Leiterplatten (10, 12) zugewandten Bereiche aus einem Material mit einer höheren Härte als das Material der ersten Kontaktflächen (14, 18) der beiden Leiterplatten (10, 12) gebildet ist und/oder die wenigstens eine Kontaktfläche (34) der zweiten Trägerplatte (24) zumindest in einem ihrer den zweiten Kontaktflächen (16, 20) der beiden Leiterplatten (10, 12) zugewandten Bereiche aus einem Material mit einer höheren Härte als das Material der zweiten Kontaktflächen (16, 20) der beiden Leiterplatten (10, 12) gebildet ist.

6. Verbindungsvorrichtung nach einem der vorhergehenden Ansprüche, **dadurch gekennzeichnet, dass**
die Vorrichtung wenigstens eine Positioniereinrichtung (40, 42, 44) zum richtigen Positionieren der Vorrichtung relativ zu den beiden Leiterplatten (10, 12) aufweist.

7. Verbindungsvorrichtung nach einem der vorhergehenden Ansprüche, **dadurch gekennzeichnet, dass**
die Vorrichtung wenigstens eine Positionshalteeinrichtung (40, 42, 44) zum Beibehalten einer richtigen Positionierung der Vorrichtung relativ zu den beiden Leiterplatten (10, 12) während eines Montagevorganges der Vorrichtung aufweist.

8. Verbindungsvorrichtung nach einem der vorhergehenden Ansprüche, **dadurch gekennzeichnet, dass**
die Spannvorrichtung (27, 28) wenigstens eine Schraube (27) aufweist, die durch entsprechende Durchgangsbohrungen (25, 26) in den beiden Trägerplatten (22, 24) geführt ist.

9. Verbindungsvorrichtung nach Anspruch 8,
**dadurch gekennzeichnet, dass**
die Vorrichtung wenigstens ein Isolierelement (40, 42) aufweist, das zumindest teilweise aus einem elektrisch isolierenden Material besteht und das entsprechend den Durchgangsbohrungen (25, 26) in den Trägerplatten (22, 24) angeordnet ist, um die wenigstens eine Schraube (27) gegen die wenigstens eine Kontaktfläche (32) der ersten Trägerplatte (22) und/oder die wenigstens eine Kontaktfläche (34) der zweiten Trägerplatte (24) zu isolieren.

10. Verbindungsvorrichtung nach einem der vorhergehenden Ansprüche, **dadurch gekennzeichnet, dass**
die Vorrichtung wenigstens eine Abstandseinrichtung (44) zum richtigen Beabstanden der beiden Leiterplatten (10, 12) zueinander aufweist.
